(19) Europäisches Patentamt
European Patent Office
Office européen des brevets

(11) **EP 3 805 319 B1**

(12) **EUROPEAN PATENT SPECIFICATION**

(45) Date of publication and mention of the grant of the patent:
**06.11.2024 Bulletin 2024/45**

(21) Application number: **18920875.4**

(22) Date of filing: **31.05.2018**

(51) International Patent Classification (IPC):
***H01L 23/29*** *(2006.01)* ***H01L 23/31*** *(2006.01)*
***C08L 63/00*** *(2006.01)* ***C08L 83/04*** *(2006.01)*
***H01L 23/00*** *(2006.01)* *H01L 23/64* *(2006.01)*

(52) Cooperative Patent Classification (CPC):
(C-Sets available)
**C08G 59/621; C08L 63/04; C08L 83/10; H01L 23/295; H01L 23/3107; H01L 23/3121; H01L 23/552; H01L 23/562;** C08G 77/445; H01L 23/645 (Cont.)

(86) International application number:
**PCT/JP2018/021056**

(87) International publication number:
**WO 2019/229961 (05.12.2019 Gazette 2019/49)**

(54) **COMPOUND, MOLDED BODY AND ELECTRONIC COMPONENT**

VERBINDUNG, FORMKÖRPER UND ELEKTRONISCHE KOMPONENTE

COMPOSÉ, CORPS MOULÉ ET COMPOSANT ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**14.04.2021 Bulletin 2021/15**

(73) Proprietor: **Resonac Corporation**
**Tokyo 105-7325 (JP)**

(72) Inventors:
- **INOUE, Hidetoshi**
  **Tokyo 100-6606 (JP)**
- **OSAKA, Masahiko**
  **Tokyo 100-6606 (JP)**
- **TAKEUCHI, Yuma**
  **Tokyo 100-6606 (JP)**
- **SEKIYA, Hiroki**
  **Tokyo 100-6606 (JP)**
- **YAMAGUCHI, Shohei**
  **Tokyo 100-6606 (JP)**
- **TAKEUCHI, Kazumasa**
  **Tokyo 100-6606 (JP)**

(74) Representative: **Hoffmann Eitle**
**Patent- und Rechtsanwälte PartmbB**
**Arabellastraße 30**
**81925 München (DE)**

(56) References cited:
**WO-A1-2012/029278**
**JP-A- 2010 138 384**
**JP-A- 2010 212 442**
**JP-A- 2014 177 591**
**JP-A- 2017 112 218**
**JP-A- H07 242 732**
**JP-A- H07 242 732**
**JP-A- H1 060 085**
**JP-A- H1 060 085**
**JP-A- H1 167 513**
**JP-A- S58 219 218**

- **XINYU DU ET AL: "Stress Reduction of Epoxy Molding Compound and Its Effect on Delamination", HIGH DENSITY PACKAGING AND MICROSYSTEM INTEGRATION, 2007 INTERNATIONAL SYMPOSIUM ON, IEEE, PI, 1 June 2007 (2007-06-01), pages 1 - 5, XP031122916, ISBN: 978-1-4244-1252-5**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08L 63/04, C08K 2003/2265, C08L 63/00**

## Description

### Technical Field

The present invention relates to a compound, a molded body, and an electronic component.

### Background Art

A compound containing a metal powder and a resin composition is used, for example, as raw materials for various industrial products such as inductors, electromagnetic shields, or bonded magnets, according to various physical properties of the metal powder (see Patent Literature 1 below). JP H07 242732 A describes an epoxy resin composition for molding which comprises, as major ingredients a specific epoxy resin, a specific coupling agent, a specific filler, an acid anhydride, and a curing accelerator in a given proportion (Patent Literature 2). JP H10 60085 describes a resin composition for molding which comprises a specific epoxy resin, an acid anhydride, a curing accelerator, a coupling agent, fine polymer particles, and an inorganic filler (Patent Literature 3). Xinyu Du et al. reports on the effect of the filler content on Epoxy Molding Compounds (EMC) comprising epoxy resin, phenolic resin, a catalyst, silica, a coupling agent, a pigment, a release agent and a stress modifier (Non-Patent Literature 1).

### Citation List

### Patent Literature

Patent Literature 1: Japanese Unexamined Patent Publication No. 2014-13803
Patent Literature 2: JP H07 242732 A
Patent Literature 3: JP H10 60085 A

Non-Patent Literature 1: Xinyu Du et al. "Stress Reduction of Epoxy Molding Compound and Its Effect on Delamination", 2007 International Symposium on High Density Packaging and Microsystem Integration, IEEE, June 2007, pages 1-5.

### Summary of Invention

### Technical Problem

In the case of manufacturing an industrial product from the compound, a molded body is produced by bringing a compound and a metallic member into close contact with each other and curing the compound, and then the molded body is heated in some cases. In the process of heating the molded body, cracks are likely to be formed in the molded body due to a difference in thermal expansion rate between a cured product of the compound and the metallic member.

The present invention has been made in view of the above-described circumstances, and an object thereof is to provide a compound with which cracks can be suppressed in a molded body produced from the compound and a metallic member, a molded body including a cured product of the compound, and an electronic component including a cured product of the compound.

### Solution to Problem

A compound according to an aspect of the present invention includes a metal element-containing powder and a resin composition, in which a content of the metal element-containing powder is 90% by mass or more and less than 100% by mass and in which a glass transition temperature of a cured product of the compound is represented as Tg [°C], a thermal expansion rate of the cured product of the compound at 25°C or higher and lower than Tg°C is represented as CTE1 [ppm/°C], a thermal expansion rate of the cured product of the compound at Tg°C or higher and 250°C or lower is represented as CTE2 [ppm/°C], a bending elastic modulus of the cured product of the compound at 250°C is represented as E [GPa], a bending strength of the cured product of the compound at 250°C is represented as $\sigma$ [MPa], and a stress index SI of the cured product of the compound defined by mathematical formula (I) below is 0 or more and 150 or less:

$$SI = |[CTE1 \times (Tg - 25) + CTE2 \times (250 - Tg) - 17 \times (250 - 25)] \times E/\sigma| \ (I),$$

a bending elongation rate of the cured product of the compound at 250°C is represented as $\varepsilon$ [%], a fracture index FI defined by mathematical formula (II) below is 3.0 MPa or more and 10.0 MPa or less:

$$FI = \varepsilon \times \sigma/2 \ (II),$$

a three-point support type bending test is executed with respect to a test piece by using an autograph equipped with a thermostat bath, the test piece is a rectangular parallelepiped consisting of the cured product of the compound, a dimension of the test piece is longitudinal width L × transverse width W × thickness t, a temperature of the thermostat bath is 250°C, one surface of the test piece is supported by two support points in the three-point support type bending test, a load is applied to the center position between the two support points in the other surface of the test piece, a load when the test piece is broken and deflection of the test piece immediately before the test piece is broken are measured, P [N] is the load when the test piece is broken, Lv [mm] is a distance between the two support points, W [mm] is the transverse width of the test piece, t [mm] is the thickness of the test piece, F/Y [N/m] is a gradient of a straight-line segment of a load-deflection curve measured by the three-point support type bending test, s [mm] is the deflection of the test piece immediately before the test piece is broken, the bending strength is calculated on the basis of mathematical formula (A) below:

$$\sigma = (3 \times P \times Lv)/(2 \times W \times t^2) \ (A),$$

the bending elastic modulus is calculated on the basis of mathematical formula (B) below:

$$E = [Lv^3/(4 \times W \times t^3)] \times (F/Y) \ (B),$$

and
the bending elongation rate is calculated on the basis of mathematical formula (C) below:

$$\varepsilon = (600 \times s \times t)/Lv^2 \ (C).$$

A molded body according to an aspect of the present invention includes a cured product of the above-described compound.

An electronic component according to an aspect of the present invention includes a cured product of the above-described compound and a device covered with the cured product of the compound, and the device has a metallic member.

**Advantageous Effects of Invention**

According to the present invention, there are provided a compound with which cracks can be suppressed in a molded body produced from the compound and a metallic member, a molded body including a cured product of the compound, and an electronic component including a cured product of the compound.

**Brief Description of Drawings**

FIG. 1 is a schematic diagram illustrating a bending test method and is a schematic side view of a bending test jig and a test piece.

FIG. 2(a) is a schematic cross-sectional view of an electronic component of an embodiment of the present invention, and FIG. 2(b) is a schematic cross-sectional view of an electronic component of another embodiment of the present invention.

FIG. 3 is a schematic cross-sectional view of an electronic circuit board of an embodiment of the present invention.

## Description of Embodiments

Hereinafter, preferred embodiments of the present invention will be described. However, the present invention is not limited to the following embodiments at all.

<Outline of compound>

A compound of the present embodiment includes a metal element-containing powder and a resin composition. The glass transition temperature of a cured product of the compound is represented as Tg [°C]. The thermal expansion rate of the cured product of the compound at 25°C or higher and lower than Tg°C is represented as CTE1 [ppm/°C]. The thermal expansion rate of the cured product of the compound at Tg°C or higher and 250°C or lower is represented as CTE2 [ppm/°C]. The bending elastic modulus of the cured product of the compound at 250°C is represented as E [GPa]. The bending strength of the cured product of the compound at 250°C is represented as $\sigma$ [MPa]. The stress index SI of the cured product of the compound defined by mathematical formula (I) below is 0 or more and 150 or less:

$$SI = |[CTE1 \times (Tg - 25) + CTE2 \times (250 - Tg) - 17 \times (250 - 25)] \times E/\sigma| \quad (I).$$

In the case of manufacturing an industrial product from the compound, a molded body is produced by bringing a compound and a metallic member into close contact with each other and curing the compound, and then the molded body is heated in some cases. In the process of heating the molded body formed from a conventional compound, cracks are likely to be formed in the molded body due to a difference in thermal expansion rate between a cured product of the compound and the metallic member. For example, when the coil is sealed with the cured product of the compound to produce an inductor and the inductor is mounted on an electronic circuit board, a reflow treatment (soldering) connecting the inductor and the electronic circuit board to each other is executed. In the reflow treatment, the inductor is heated in the state of the cured product of the compound being in close contact with the coil. In a conventional process of heating the inductor, cracks are likely to be formed in the inductor due to a difference in thermal expansion rate between the cured product of the compound and the coil. Cracks are likely to be formed inside the coil. When cracks are formed in the inductor, inductance of the inductor is decreased. Only by decreasing a difference in thermal expansion rate between the cured product of the conventional compound and the metallic member, cracks cannot be sufficiently suppressed. The present inventors have found out that, by using a compound in which a stress index SI defined by the above-described mathematical formula (I) is 0 or more and 150 or less, cracks generated due to a difference in thermal expansion rate between a cured product of the compound and a metallic member can be suppressed.

$[CTE1 \times (Tg - 25) + CTE2 \times (250 - Tg) - 17 \times (250 - 25)]$ in mathematical formula (I) may be restated as a difference D in expansion amount between the cured product of the compound and the metallic member (for example, copper) at 25°C or higher and 250°C or lower. That is, SI defined by the above-described mathematical formula (I) may be represented as $D \times E/\sigma$. As D is smaller, SI is smaller, and thus cracks are difficult to be formed. As the above-described bending elastic modulus E is smaller, SI is smaller, and thus cracks are difficult to be formed. As the above-described bending strength $\sigma$ is greater, SI is smaller, and thus cracks are difficult to be formed. When SI is 0 or more and 150 or less, a stress acting on the molded body according to a temperature change of the molded body is sufficiently reduced, and thus cracks of the molded body is suppressed. 150 that is the upper limit value of SI is firstly found out by the research of the present inventors. However, the function effect of the present invention is not limited to the above-described matters. SI may be freely adjusted according to the composition and the amount of the metal element-containing powder, the composition and the amount of the resin composition, and the like contained in the compound.

The stress index SI may be 0 or more and 140 or less, 0 or more and 135 or less, 0 or more and 130 or less, 0 or more and 100 or less, or 0 or more and 70 or less. In a case where SI is within the above-described range, cracks of a molded body formed from the compound are easily suppressed.

The bending elongation rate of the cured product of the compound at 250°C is represented as $\varepsilon$ [%]. The fracture index FI defined by mathematical formula (II) below is 3.0 MPa or more and 10.0 MPa or less, and may be 4 MPa or more and 9.0 MPa or less. FI is a numerical value represented by the product of the bending strength (MPa) and the bending elongation rate (%). In a case where FI is within the above-described range, cracks of a molded body formed from the compound are easily suppressed. FI may be freely adjusted according to the composition and the amount of the metal element-containing powder, the composition and the amount of the resin composition, and the like contained in the compound.

$$FI = \varepsilon \times \sigma/2 \text{ (II)}$$

The metal element-containing powder is constituted by a plurality (a large number) of metal element-containing particles. The metal element-containing powder (metal element-containing particle) may contain, for example, at least one selected from the group consisting of a simple metal, an alloy, and a metal chemical compound. The resin composition contains at least a resin. For example, the resin composition may contain an epoxy resin. The resin composition may contain other components in addition to a resin. For example, the resin composition may contain a chemical compound having a siloxane bond. The chemical compound having a siloxane bond is referred to as the "siloxane chemical compound" in some cases. The resin composition may contain a curing agent. The resin composition may contain a curing accelerator. The resin composition may contain an additive. The resin composition is a component which may contain a resin, a siloxane chemical compound, a curing agent, a curing accelerator, and an additive, and may be a remaining component (non-volatile component) excluding an organic solvent and the metal element-containing powder. The additive is a remaining component of the resin composition excluding a resin, a siloxane chemical compound, a curing agent, and a curing accelerator. The additive is, for example, a coupling agent, a flame retardant, or the like. The resin composition may contain a wax as the additive. The compound may be a powder (compound powder).

The compound may include a metal element-containing powder and a resin composition adhering to a surface of each metal element-containing particle constituting the metal element-containing powder. The resin composition may cover the entire surface of the particle and may cover only a part of the surface of the particle. The compound may include the resin composition which is uncured and the metal element-containing powder. The compound may include a semi-cured product of the resin composition (for example, B-stage resin composition) and the metal element-containing powder. The compound may include both the resin composition which is uncured and the semi-cured product of the resin composition. The compound may consist of the metal element-containing powder and the resin composition.

From the viewpoint of easily adjusting SI and FI in the above-described ranges, according to the present invention the content of the metal element-containing powder in the compound is 90% by mass or more and less than 100% by mass, and may be 90% by mass or more and 99.8% by mass or less, 92% by mass or more and 99.8% by mass or less, or 94% by mass or more and 99.8% by mass or less, with respect to the mass of the entire compound. The compound may contain other fillers (for example, a silica filler) in addition to the metal element-containing powder.

From the viewpoint of easily adjusting SI and FI in the above-described ranges, the content of the resin composition in the compound may be 0.2% by mass or more and 10% by mass or less, or 4% by mass or more and 6% by mass or less, with respect to the mass of the entire compound (for example, the total mass of the metal element-containing powder and the resin composition).

The average particle size of the metal element-containing powder is not particularly limited, and may be, for example, 1 μm or more and 300 μm or less. The average particle size may be measured, for example, by a particle size distribution meter. The shape of each metal element-containing particle constituting the metal element-containing powder is not limited, and may be, for example, a spherical shape, a flat shape, a prismatic shape, or a needle shape. The compound may include a plurality of kinds of metal element-containing powders each having a different average particle size.

Various characteristics such as electromagnetic characteristics of a molded body formed from the compound are freely controlled according to the composition or the combination of the metal element-containing powder contained in the compound, and the molded body can be used for various industrial products or raw materials therefor. Industrial products produced using the compound may be, for example, automobiles, medical equipment, electronic equipment, electrical equipment, information communications equipment, home electronics, sound equipment, and general industrial equipment. For example, in a case where the compound contains a permanent magnet such as an Sm-Fe-N-based alloy or an Nd-Fe-B-based alloy as the metal element-containing powder, the compound may be used as raw materials for a bonded magnet. In a case where the compound contains a soft magnetic powder such as an Fe-Si-Cr-based alloy or ferrite as the metal element-containing powder, the compound may be used as raw materials (for example, a magnetic core or a sealing material) for an inductor (for example, an EMI filter) or a transformer. In a case where the compound contains iron and copper as the metal element-containing powder, a molded body (for example, a sheet) formed from the compound may be used as an electromagnetic shield.

<Composition of compound>

(Resin composition)

The resin composition has a function as a bonding material (binder) of the metal element-containing particle constituting the metal element-containing powder and provides the mechanical strength to a molded body formed from the compound. For example, when the compound is molded at a high pressure by using a mold, the resin composition

is filled between the metal element-containing particles and binds the metal element-containing particles to each other. The resin composition in the molded body is cured, and thereby the cured product of the resin composition more firmly binds the metal element-containing particles to each other, so that the mechanical strength of the molded body is improved.

The resin composition contains at least a resin. The resin composition may contain an epoxy resin as the thermosetting resin. When the compound contains an epoxy resin relatively excellent in fluidity among thermosetting resins, and thereby the fluidity, the storage stability, and the moldability of the compound are improved. However, the compound may contain other resins in addition to the epoxy resin as long as the effect of the present invention is not impaired. For example, the resin composition may contain at least one of a phenolic resin and a polyamide-imide resin as the thermosetting resin. In a case where the resin composition contains both of an epoxy resin and a phenolic resin, the phenolic resin may function as a curing agent for the epoxy resin. The resin composition may contain a thermoplastic resin. The thermoplastic resin may be, for example, at least one selected from the group consisting of an acrylic resin, polyethylene, polypropylene, polystyrene, polyvinyl chloride, and polyethylene terephthalate. The resin composition may contain both of a thermosetting resin and a thermoplastic resin. The resin composition may contain a silicone resin.

The epoxy resin may be, for example, a resin having two or more epoxy groups in one molecule. The epoxy resin may be, for example, at least one selected from the group consisting of a biphenyl type epoxy resin, a stilbene type epoxy resin, a diphenylmethane type epoxy resin, a sulfur atom-containing type epoxy resin, a novolac type epoxy resin, a dicyclopentadiene type epoxy resin, a salicylaldehyde type epoxy resin, a copolymer type epoxy resin of naphthols and phenols, an epoxide of aralkyl type epoxy resin, a bisphenol type epoxy resin, an epoxy resin having a bisphenol skeleton, a glycidyl ether type epoxy resin of alcohols, a glycidyl ether type epoxy resin of a para-xylylene and/or meta-xylylene-modified phenolic resin, a glycidyl ether type epoxy resin of a terpene-modified phenolic resin, a cyclopentadiene type epoxy resin, a glycidyl ether type epoxy resin of a polycyclic aromatic ring-modified phenolic resin, a glycidyl ether type epoxy resin of a naphthalene ring-containing phenolic resin, a glycidyl ester type epoxy resin, a glycidyl type or methylglycidyl type epoxy resin, an alicyclic type epoxy resin, a halogenated phenol novolac type epoxy resin, an ortho-cresol novolac type epoxy resin, a hydroquinone type epoxy resin, a trimethylolpropane type epoxy resin, and a linear aliphatic epoxy resin obtained by oxidation of an olefin bond with a peracid such as peracetic acid.

From the viewpoint of having excellent fluidity, the epoxy resin may be at least one selected from the group consisting of a biphenyl type epoxy resin, an ortho-cresol novolac type epoxy resin, a phenol novolac type epoxy resin, a bisphenol type epoxy resin, an epoxy resin having a bisphenol skeleton, a salicylaldehyde novolac type epoxy resin, and a naphthol novolac type epoxy resin.

The epoxy resin may be a crystalline epoxy resin. Although the molecular weight of the crystalline epoxy resin is relatively low, the crystalline epoxy resin has a relatively high melting point and is excellent in fluidity. The crystalline epoxy resin (epoxy resin having high crystallizability) may be, for example, at least one selected from the group consisting of a hydroquinone type epoxy resin, a bisphenol type epoxy resin, a thioether type epoxy resin, and a biphenyl type epoxy resin. A commercially available product of the crystalline epoxy resin may be, for example, at least one selected from the group consisting of EPICLON 860, EPICLON 1050, EPICLON 1055, EPICLON 2050, EPICLON 3050, EPICLON 4050, EPICLON 7050, EPICLON HM-091, EPICLON HM-101, EPICLON N-730A, EPICLON N-740, EPICLON N-770, EPICLON N-775, EPICLON N-865, EPICLON HP-4032D, EPICLON HP-7200L, EPICLON HP-7200, EPICLON HP-7200H, EPICLON HP-7200HH, EPICLON HP-7200HHH, EPICLON HP-4700, EPICLON HP-4710, EPICLON HP-4770, EPICLON HP-5000, EPICLON HP-6000, N500P-2, and N500P-10 (all of which are manufactured by DIC Corporation, trade names), NC-3000, NC-3000-L, NC-3000-H, NC-3100, CER-3000-L, NC-2000-L, XD-1000, NC-7000-L, NC-7300-L, EPPN-501H, EPPN-501HY, EPPN-502H, EOCN-1020, EOCN-102S, EOCN-103S, EOCN-104S, CER-1020, EPPN-201, BREN-S, and BREN-10S (all of which are manufactured by Nippon Kayaku Co., Ltd., trade names), and YX-4000, YX-4000H, YL4121H, and YX-8800 (all of which are manufactured by Mitsubishi Chemical Corporation, trade names).

From the viewpoints of easily adjusting SI and FI within the above-described ranges and easily suppressing cracks of a molded body formed from the compound, the resin composition may contain at least one of a biphenylene aralkyl type epoxy resin and an isocyanate-modified epoxy resin as the epoxy resin. The resin composition may contain both the biphenylene aralkyl type epoxy resin and the isocyanate-modified epoxy resin as the epoxy resin. A commercially available product of the biphenylene aralkyl type epoxy resin may be, for example, NC-3000 manufactured by Nippon Kayaku Co., Ltd. A commercially available product of the isocyanate-modified epoxy resin may be, for example, AER-4001 manufactured by Asahi Kasei Corp. (former Asahi Kasei E-materials Corp.).

The resin composition may contain one kind of the above-described epoxy resins. The resin composition may contain a plurality of kinds of the above-described epoxy resins.

The curing agent is classified into a curing agent which cures the epoxy resin in a range of a low temperature to room temperature and a heat curing type curing agent which cures the epoxy resin by heating. Examples of the curing agent which cures the epoxy resin in a range of a low temperature to room temperature include aliphatic polyamine, polyaminoamide, and polymercaptan. Examples of the heat curing type curing agent include aromatic polyamine, acid anhydride, a phenol novolac resin, and dicyandiamide (DICY).

In the case of using the curing agent which cures the epoxy resin in a range of a low temperature to room

temperature, the glass transition point of a cured product of the epoxy resin is low, and the cured product of the epoxy resin tends to be soft. As a result, a molded body formed from the compound is also likely to be soft. On the other hand, from the viewpoint of improving heat resistance of the molded body, the curing agent may be preferably a heat curing type curing agent, more preferably a phenolic resin, and even more preferably a phenol novolac resin. In particular, by using a phenol novolac resin as the curing agent, a cured product of the epoxy resin having a high glass transition point is easily obtained. As a result, the heat resistance and the mechanical strength of the molded body are likely to be improved.

The phenolic resin may be, for example, at least one selected from the group consisting of an aralkyl type phenolic resin, a dicyclopentadiene type phenolic resin, a salicylaldehyde type phenolic resin, a novolac type phenolic resin, a copolymer type phenolic resin of benzaldehyde type phenol and aralkyl type phenol, a para-xylylene and/or meta-xylylene-modified phenolic resin, a melamine-modified phenolic resin, a terpene-modified phenolic resin, a dicyclopentadiene type naphthol resin, a cyclopentadiene-modified phenolic resin, a polycyclic aromatic ring-modified phenolic resin, a biphenyl type phenolic resin, and a triphenylmethane type phenolic resin. The phenolic resin may be a copolymer composed of two or more kinds of the above-described resins. As commercially available products of the phenolic resin, for example, TAMANOL 758 manufactured by ARAKAWA CHEMICAL INDUSTRIES, LTD., or HP-850N manufactured by Hitachi Chemical Company, Ltd., or the like may be used.

The phenol novolac resin may be, for example, a resin obtained by condensing or co-condensing phenols and/or naphthols and aldehydes in the presence of an acidic catalyst. Phenols constituting the phenol novolac resin may be, for example, at least one selected from the group consisting of phenol, cresol, xylenol, resorcin, catechol, bisphenol A, bisphenol F, phenylphenol, and aminophenol. Naphthols constituting the phenol novolac resin may be, for example, at least one selected from the group consisting of $\alpha$-naphthol, $\beta$-naphthol, and dihydroxynaphthalene. Aldehydes constituting the phenol novolac resin may be, for example, at least one selected from the group consisting of formaldehyde, acetaldehyde, propionaldehyde, benzaldehyde, and salicylaldehyde.

The curing agent may be, for example, a chemical compound having two phenolic hydroxyl groups in one molecule. The chemical compound having two phenolic hydroxyl groups in one molecule may be, for example, at least one selected from the group consisting of resorcin, catechol, bisphenol A, bisphenol F, and a substituted or unsubstituted biphenol.

The resin composition may contain one kind of the above-described phenolic resins. The resin composition may include a plurality of kinds of the above-described phenolic resins. The resin composition may contain one kind of the above-described curing agents. The resin composition may contain a plurality of kinds of the above-described curing agents.

The ratio of the active group (phenolic OH group) in the curing agent which reacts with the epoxy group in the epoxy resin may be preferably 0.5 to 1.5 equivalents and more preferably 0.75 to 1.25 equivalents, with respect to one equivalent of the epoxy group in the epoxy resin. In a case where ratio of the active group in the curing agent is within the above-described range, the fluidity of the compound is likely to be improved.

For example, the curing accelerator is not limited as long as it is a composition that reacts with the epoxy resin to accelerate curing of the epoxy resin. The curing accelerator may be, for example, imidazoles such as alkyl group-substituted imidazole or benzoimidazole. The resin composition may include one kind of curing accelerators. The resin composition may include a plurality of kinds of curing accelerators. When the resin composition contains a curing accelerator, the moldability and the releasability of the compound are likely to be improved. Furthermore, when the resin composition contains a curing accelerator, the mechanical strength of a molded body (for example, an electronic component) produced using the compound may be improved or the storage stability of the compound in a high-temperature and high-humidity environment may be improved. As commercially available products of the imidazole-based curing accelerator, for example, at least one selected from the group consisting of 2MZ-H, C11Z, C17Z, 1,2DMZ, 2E4MZ, 2PZ-PW, 2P4MZ, 1B2MZ, 1B2PZ, 2MZ-CN, C11Z-CN, 2E4MZ-CN, 2PZ-CN, C11Z-CNS, 2P4MHZ, TPZ, and SFZ (all of which are manufactured by SHIKOKU CHEMICALS CORPORATION, trade names) may be used.

The mixing amount of the curing accelerator is sufficient to be an amount in which the curing acceleration effect is obtainable, and the mixing amount is not particularly limited. However, from the viewpoint of improving curing property and fluidity when the resin composition absorbs moisture, the mixing amount of the curing accelerator may be preferably 0.1 parts by mass or more and 30 parts by mass or less and more preferably 1 part by mass or more and 15 parts by mass or less, with respect to 100 parts by mass of the epoxy resin. The content of the curing accelerator is preferably 0.001 parts by mass or more and 5 parts by mass or less with respect to 100 parts by mass of the total mass of the epoxy resin and the curing agent (for example, a phenolic resin). In a case where the mixing amount of the curing accelerator is less than 0.1 parts by mass, it is difficult to obtain a sufficient curing acceleration effect. In a case where the mixing amount of the curing accelerator is more than 30 parts by mass, the storage stability of the compound is likely to be decreased. However, even in a case where the mixing amount and the content of the curing accelerator are out of the above-described ranges, the effect of the present invention is obtainable.

From the viewpoints of easily adjusting SI and FI within the above-described ranges and easily suppressing

cracks of a molded body formed from the compound, the resin composition may contain a chemical compound having a siloxane bond (siloxane chemical compound). The siloxane bond is a bond including two silicon atoms (Si) and one oxygen atom (O) and may be represented by -Si-O-Si-. The resin composition may contain one kind of siloxane chemical compounds or may contain a plurality of kinds of siloxane chemical compounds. From the viewpoints of easily adjusting SI and FI within the above-described ranges and easily suppressing cracks of a molded body formed from the compound, the resin composition preferably contains at least any one of a first siloxane chemical compound and a second siloxane chemical compound described below, as the siloxane chemical compound. The resin composition may contain only the first siloxane chemical compound or may contain only the second siloxane chemical compound as the siloxane chemical compound. The resin composition may contain both the first siloxane chemical compound and the second siloxane chemical compound. The resin composition may contain a siloxane chemical compound other than the first siloxane chemical compound and the second siloxane chemical compound. Hereinafter, the details of the first siloxane chemical compound and the second siloxane chemical compound will be specifically described.

The first siloxane chemical compound may have a structural unit represented by chemical formula (1) below. The structural unit represented by chemical formula (1) below is referred to as the "structural unit 1" in some cases.

[Chemical Formula 1]

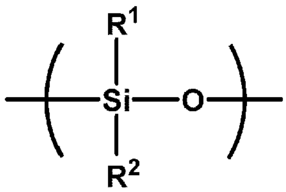

(1)

In the above-described chemical formula (1), $R^1$ and $R^2$ are each independently an alkyl group having 1 to 10 carbon atoms, an aryl group having 6 to 10 carbon atoms, an alkoxy group having 1 to 10 carbon atoms, a monovalent organic group having an epoxy group, a monovalent organic group having a carboxy group, or a polyalkylene ether group having 3 to 500 carbon atoms.

The first siloxane chemical compound may have a plurality of structural units 1. A plurality of $R^1$ existing in the first siloxane chemical compound may be the same as or different from each other. A plurality of $R^2$ existing in the first siloxane chemical compound may be the same as or different from each other. $R^1$ and $R^2$ may be the same as or different from each other. The first siloxane chemical compound may have a repeating unit represented by the above-described chemical formula (1).

From the viewpoints of easily adjusting SI and FI within the above-described ranges and easily suppressing cracks of a molded body formed from the compound, the first siloxane chemical compound preferably has a structural unit represented by chemical formula (2) below. The structural unit represented by chemical formula (2) below is referred to as the "structural unit 2" in some cases.

[Chemical Formula 2]

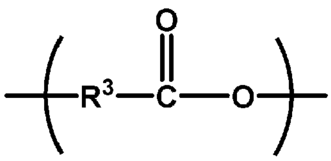

(2)

In the above-described chemical formula (2), $R^3$ is an alkylene group having 1 to 10 carbon atoms.

The first siloxane chemical compound may have a plurality of structural units 2. A plurality of $R^3$ existing in the first siloxane chemical compound may be the same as or different from each other. The first siloxane chemical compound may have a repeating unit represented by the above-described chemical formula (2).

From the viewpoints of easily adjusting SI and FI within the above-described ranges and easily suppressing cracks of a molded body formed from the compound, the first siloxane chemical compound is preferably a chemical compound represented by chemical formula (3) below. The chemical compound represented by chemical formula (3) below is referred to as the "chemical compound 3" in some cases.

[Chemical Formula 3]

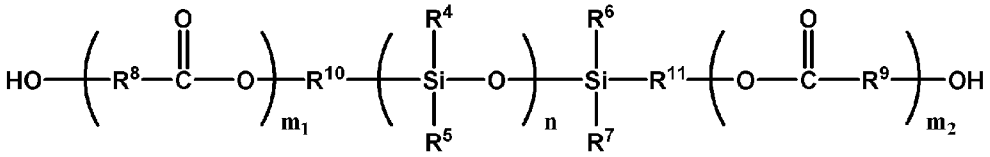 (3)

In the above-described chemical formula (3), n is an integer of 1 to 200. $m_1$ and $m_2$ are each independently an integer of 1 to 200. $R^4$, $R^5$, $R^6$, and $R^7$ are each independently an alkyl group having 1 to 10 carbon atoms, an aryl group having 6 to 10 carbon atoms, an alkoxy group having 1 to 10 carbon atoms, a monovalent organic group having an epoxy group, a monovalent organic group having a carboxy group, or a polyalkylene ether group having 3 to 500 carbon atoms. $R^8$ and $R^9$ are each independently an alkylene group having 1 to 10 carbon atoms. $R^{10}$ and $R^{11}$ are each independently a bivalent hydrocarbon group having 1 to 10 carbon atoms.

A plurality of $R^4$ existing in the chemical compound 3 may be the same as or different from each other. A plurality of $R^5$ existing in the chemical compound 3 may be the same as or different from each other. $R^4$, $R^5$, $R^6$, and $R^7$ may be the same as or different from each other. A plurality of $R^8$ existing in the chemical compound 3 may be the same as or different from each other. A plurality of $R^9$ existing in the chemical compound 3 may be the same as or different from each other. $R^8$ and $R^9$ may be the same as or different from each other. The weight average molecular weight (Mw) of the chemical compound 3 may be, for example, 4000 or more and 20000 or less.

A commercially available product of the chemical compound 3 may be, for example, DBL-C31, DBL-C32, or the like manufactured by Gelest Inc.

From the viewpoints of easily adjusting SI and FI within the above-described ranges and easily suppressing cracks of a molded body formed from the compound, the second siloxane chemical compound preferably has a structural unit represented by chemical formula (4) below and a structural unit represented by chemical formula (5) below. The structural unit represented by chemical formula (4) below is referred to as the "structural unit 4" in some cases. The structural unit represented by chemical formula (5) below is referred to as the "structural unit 5" in some cases.

[Chemical Formula 4]

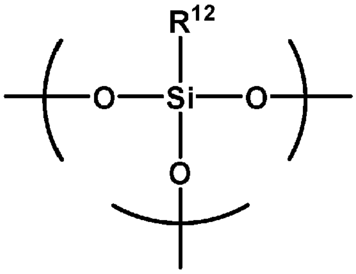 (4)

In the above-described chemical formula (4), $R^{12}$ is a monovalent hydrocarbon group having 1 to 12 carbon atoms.

$R^{12}$ may be, for example, an alkyl group such as a methyl group, an ethyl group, a propyl group, a butyl group, an isopropyl group, an isobutyl group, a t-butyl group, a pentyl group, a hexyl group, a heptyl group, an octyl group, a 2-ethylhexyl group; an alkenyl group such as a vinyl group, an allyl group, a butenyl group, a pentenyl group, or a hexenyl group; an aryl group such as a phenyl group, a tolyl group, a xylyl group, a naphthyl group, or a biphenyl group; an aralkyl group such as a benzyl group or a phenethyl group; and the like. $R^{12}$ is preferably a methyl group or a phenyl group.

The second siloxane chemical compound may have a plurality of structural units 4. A plurality of $R^{12}$ existing in the second siloxane chemical compound may be the same as or different from each other. The second siloxane chemical compound may have a repeating unit represented by the above-described chemical formula (4).

[Chemical Formula 5]

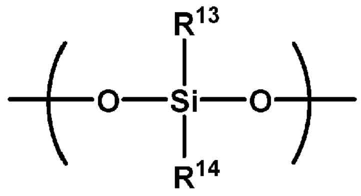

(5)

In the above-described chemical formula (5), $R^{13}$ and $R^{14}$ are each independently a monovalent hydrocarbon group having 1 to 12 carbon atoms.

$R^{13}$ may be, for example, an alkyl group such as a methyl group, an ethyl group, a propyl group, a butyl group, an isopropyl group, an isobutyl group, a t-butyl group, a pentyl group, a hexyl group, a heptyl group, an octyl group, a 2-ethylhexyl group; an alkenyl group such as a vinyl group, an allyl group, a butenyl group, a pentenyl group, or a hexenyl group; an aryl group such as a phenyl group, a tolyl group, a xylyl group, a naphthyl group, or a biphenyl group; an aralkyl group such as a benzyl group or a phenethyl group; and the like. $R^{13}$ is preferably a methyl group or a phenyl group.

$R^{14}$ may be, for example, an alkyl group such as a methyl group, an ethyl group, a propyl group, a butyl group, an isopropyl group, an isobutyl group, a t-butyl group, a pentyl group, a hexyl group, a heptyl group, an octyl group, a 2-ethylhexyl group; an alkenyl group such as a vinyl group, an allyl group, a butenyl group, a pentenyl group, or a hexenyl group; an aryl group such as a phenyl group, a tolyl group, a xylyl group, a naphthyl group, or a biphenyl group; an aralkyl group such as a benzyl group or a phenethyl group; and the like. $R^{14}$ is preferably a methyl group or a phenyl group.

The second siloxane chemical compound may have a plurality of structural units 5. A plurality of $R^{13}$ existing in the second siloxane chemical compound may be the same as or different from each other. A plurality of $R^{14}$ existing in the second siloxane chemical compound may be the same as or different from each other. $R^{13}$ and $R^{14}$ may be the same as or different from each other. The second siloxane chemical compound may have a repeating unit represented by the above-described chemical formula (5).

From the viewpoint of the storage stability of the second siloxane chemical compound, the terminal of the molecule of the second siloxane chemical compound is preferably any one group of $R^{12}$, $R^{13}$, $R^{14}$, a hydroxyl group, and an alkoxy group. The alkoxy group may be, for example, a methoxy group, an ethoxy group, a propoxy group, or a butoxy group.

From the viewpoints of easily adjusting SI and FI within the above-described ranges and easily suppressing cracks of a molded body formed from the compound, the second siloxane chemical compound preferably has a structural unit represented by chemical formula (6) below. The structural unit represented by chemical formula (6) below is referred to as the "structural unit 6" in some cases.

[Chemical Formula 6]

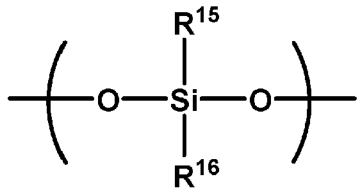

(6)

In the above-described chemical formula (6), $R^{15}$ is a monovalent hydrocarbon group having 1 to 12 carbon atoms. $R^{16}$ is a monovalent organic group having an epoxy group.

$R^{15}$ may be, for example, an alkyl group such as a methyl group, an ethyl group, a propyl group, a butyl group, an isopropyl group, an isobutyl group, a t-butyl group, a pentyl group, a hexyl group, a heptyl group, an octyl group, a 2-ethylhexyl group; an alkenyl group such as a vinyl group, an allyl group, a butenyl group, a pentenyl group, or a hexenyl group; an aryl group such as a phenyl group, a tolyl group, a xylyl group, a naphthyl group, or a biphenyl group; an aralkyl group such as a benzyl group or a phenethyl group; and the like. $R^{13}$ is preferably a methyl group or a phenyl group.

$R^{16}$ may be, for example, a 2,3-epoxypropyl group, a 3,4-epoxybutyl group, a 4,5-epoxypentyl group, a 2-glycidoxyethyl group, a 3-glycidoxypropyl group, a 4-glycidoxybutyl group, a 2-(3,4-epoxycyclohexyl)ethyl group, a 3-(3,4-epoxycyclohexyl)propyl group, and the like. $R^{16}$ is preferably a 3-glycidoxypropyl group.

The second siloxane chemical compound may have a plurality of structural units 6. A plurality of $R^{15}$ existing in the second siloxane chemical compound may be the same as or different from each other. A plurality of $R^{16}$ existing in the second siloxane chemical compound may be the same as or different from each other. The second siloxane chemical compound may have a repeating unit represented by the above-described chemical formula (6).

From the viewpoints of easily adjusting SI and FI within the above-described ranges and easily suppressing cracks of a molded body formed from the compound, the second siloxane chemical compound is preferably a chemical compound having at least one structural unit selected from the group consisting of a structural unit represented by chemical formula (7) below, a structural unit represented by chemical formula (8) below, a structural unit represented by chemical formula (9) below, and a structural unit represented by chemical formula (10) below. The structural unit represented by chemical formula (7) below is referred to as the "structural unit 7" in some cases. The structural unit represented by chemical formula (8) below is referred to as the "structural unit 8" in some cases. The structural unit represented by chemical formula (9) below is referred to as the "structural unit 9" in some cases. The structural unit represented by chemical formula (10) below is referred to as the "structural unit 10" in some cases. The chemical compound having at least one structural unit selected from the group consisting of the structural unit 7, the structural unit 8, the structural unit 9, and the structural unit 10 described above is referred to as the "chemical compound 11" in some cases. The chemical compound 11 may have all of the structural unit 7, the structural unit 8, the structural unit 9, and the structural unit 10.

[Chemical Formula 7]

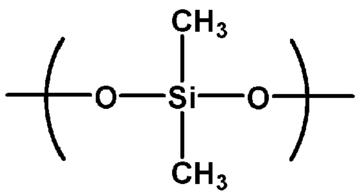

(7)

[Chemical Formula 8]

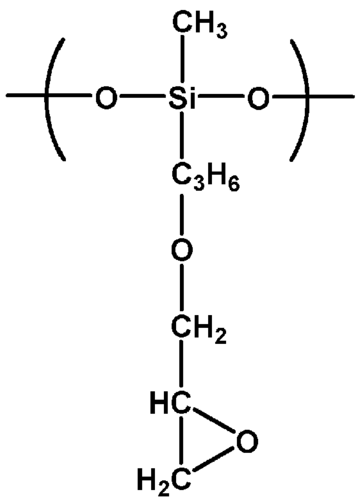

(8)

[Chemical Formula 9]

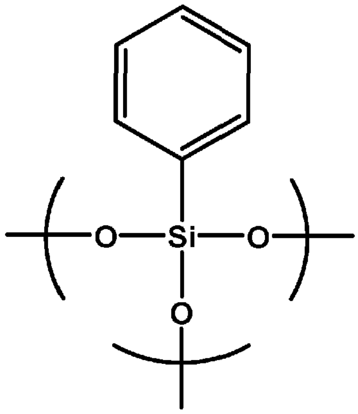

(9)

[Chemical Formula 10]

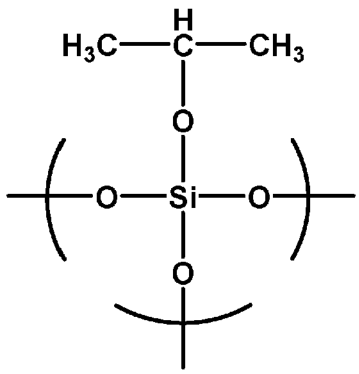

(10)

The chemical compound 11 may have a plurality of structural units 7. The chemical compound 11 may have a repeating unit represented by the above-described chemical formula (7). The chemical compound 11 may have a plurality of structural units 8. The chemical compound 11 may have a repeating unit represented by the above-described chemical formula (8). The chemical compound 11 may have a plurality of structural units 9. The chemical compound 11 may have a repeating unit represented by the above-described chemical formula (9). The chemical compound 11 may have a plurality of structural units 10. The chemical compound 11 may have a repeating unit represented by the above-described chemical formula (10).

A commercially available product of the chemical compound 11 may be, for example, AY42-119 manufactured by Toray Dow Coming Co., Ltd.

The epoxy equivalent of the second siloxane chemical compound may be 500 or more and 4000 or less, or 1000 or more and 2500 or less. In a case where the epoxy equivalent is within the above-described range, the fluidity of the compound is likely to be improved, and the moldability is likely to be improved.

The softening point of the second siloxane chemical compound is preferably 40°C or higher and 120°C or lower and more preferably 50°C or higher and 100°C or lower. In a case where the softening point is within the above-described range, the mechanical strength of a molded body formed from the compound is likely to be improved. The softening point of the second siloxane chemical compound may be adjusted by the molecular weight and the structure (for example, the content ratio of each constituent unit) of the second siloxane chemical compound, the type of the organic group to be bonded to a silicon atom, and the like. From the viewpoint of the fluidity of the compound, the softening point is preferably adjusted by the content of the aryl group in the second siloxane chemical compound. The aryl group may be, for example, a phenyl group, a tolyl group, a xylyl group, a naphthyl group, a biphenyl group, and the like. The aryl group is preferably a phenyl group. The softening point is more preferably adjusted by the content of the phenyl group in the monovalent organic group to be bonded to a silicon atom in the second siloxane chemical compound. The content of the phenyl group may be adjusted to preferably 60 mol% or more and 100 mol% or less and more preferably 70 mol%

or more and 85 mol% or less.

The weight average molecular weight (Mw) of the second siloxane chemical compound may be 1000 or more and 30000 or less, preferably 2000 or more and 20000 or less, and more preferably 3000 or more and 10000 or less. The weight average molecular weight (Mw) may be measured by gel permeation chromatography (GPC) and may be a value converted using a standard polystyrene calibration curve. The second siloxane chemical compound is preferably a random copolymer.

The resin composition may contain one kind of the above-described siloxane chemical compounds or may contain a plurality of kinds of the above-described siloxane chemical compounds.

The content of the siloxane chemical compound in the compound may be 25 parts by mass or more and 45 parts by mass or less, 25 parts by mass or more and 35 parts by mass or less, or 30 parts by mass or more and 35 parts by mass or less, with respect to 100 parts by mass of the epoxy resin. In a case where the content of the siloxane chemical compound is within the above-described range, SI and FI are easily adjusted within the above-described ranges, and cracks of a molded body formed from the compound are easily suppressed.

The coupling agent improves adhesiveness between the resin composition and the metal element-containing particle constituting the metal element-containing powder and improves the flexibility and the mechanical strength of a molded body formed from the compound. The coupling agent may be, for example, at least one selected from the group consisting of a silane-based chemical compound (silane coupling agent), a titanium-based chemical compound, an aluminum chemical compound (aluminum chelates), and an aluminum/zirconium-based chemical compound. The silane coupling agent may be, for example, at least one selected from the group consisting of epoxysilane, mercaptosilane, aminosilane, alkylsilane, ureidosilane, acid anhydride-based silane, and vinylsilane. In particular, an aminophenyl-based silane coupling agent is preferred. The resin composition may contain one kind of the above-described coupling agents or may contain a plurality of kinds of the above-described coupling agents.

For environment safety, recyclability, molding processability, and cost saving of the compound, the compound may contain a flame retardant. The flame retardant may be, for example, at least one selected from the group consisting of a bromine-based flame retardant, a phosphorus-based flame retardant, a hydrated metal chemical compound-based flame retardant, a silicone-based flame retardant, a nitrogen-containing chemical compound, a hindered amine chemical compound, an organometallic chemical compound, and aromatic engineering plastic. The resin composition may contain one kind of the above-described flame retardants or may contain a plurality of kinds of the above-described flame retardants.

In the case of forming a molded body from the compound by using a mold, the resin composition may contain a wax. The wax increases the fluidity of the compound in the molding (for example, transfer molding) of the compound and functions as a release agent. The wax may be at least any one of a fatty acid such as higher fatty acid and a fatty acid ester.

The wax may be, for example, at least one selected from the group consisting of fatty acids or esters thereof such as montanoic acid, stearic acid, 12-oxystearic acid, and lauric acid; fatty acid salts such as zinc stearate, calcium stearate, barium stearate, aluminum stearate, magnesium stearate, calcium laurate, zinc linoleate, calcium ricinoleate, and zinc 2-ethylhexoate; fatty acid amides such as stearic acid amide, oleic acid amide, erucic acid amide, behenic acid amide, palmitic acid amide, lauric acid amide, hydroxystearic acid amide, methylenebis stearic acid amide, ethylenebis stearic acid amide, ethylenebis lauric acid amide, distearyl adipic acid amide, ethylenebis oleic acid amide, dioleyl adipic acid amide, N-stearyl stearic acid amide, N-oleyl stearic acid amide, N-stearyl erucic acid amide, methylol stearic acid amide, and methylol behenic acid amide; fatty acid esters such as butyl stearate; alcohols such as ethylene glycol and stearyl alcohol; polyethyleneglycol, polypropylene glycol, polytetramethylene glycol, and polyethers composed of modified products of these; polysiloxanes such as silicone oil, silicone grease; fluorine chemical compounds such as fluorine-based oil, fluorine-based grease, and fluorine-containing resin powder; and waxes such as paraffin wax, polyethylene wax, amide wax, polypropylene wax, ester wax, carnauba wax, and micro wax.

(Metal element-containing powder)

The metal element-containing powder (metal element-containing particle) may contain, for example, at least one selected from the group consisting of a simple metal, an alloy, and a metal chemical compound. The metal element-containing powder may be composed of, for example, at least one selected from the group consisting of a simple metal, an alloy, and a metal chemical compound. The alloy may contain at least one selected from the group consisting of a solid solution, a eutectic compound, and an intermetallic chemical compound. The alloy may be, for example, stainless steel (an Fe-Cr-based alloy, an Fe-Ni-Cr-based alloy, or the like). The metal chemical compound may be, for example, an oxide such as ferrite. The metal element-containing powder may contain one kind of metal elements or may contain a plurality of kinds of metal elements. The metal element contained in the metal element-containing powder may be, for example, a base metal element, a noble metal element, a transition metal element, or a rare-earth element. The compound may contain one kind of metal element-containing powders or may contain a plurality of kinds of metal element-containing

powders each having a different composition.

The metal element-containing powder is not limited to the above-described composition. The metal element contained in the metal element-containing powder may be, for example, at least one selected from the group consisting of iron (Fe), copper (Cu), titanium (Ti), manganese (Mn), cobalt (Co), nickel (Ni), zinc (Zn), aluminum (Al), tin(Sn), chromium (Cr), barium (Ba), strontium (Sr), lead (Pb), silver (Ag), praseodymium (Pr), neodymium (Nd), samarium (Sm), and dysprosium (Dy). The metal element-containing powder may further contain elements other than the metal element. The metal element-containing powder may contain, for example, oxygen (O), beryllium (Be), phosphorus (P), boron (B), or silicon (Si). The metal element-containing powder may be a magnetic powder. The metal element-containing powder may be a soft magnetic alloy or a ferromagnetic alloy. The metal element-containing powder may be, for example, a magnetic powder composed of at least one selected from the group consisting of an Fe-Si-based alloy, an Fe-Si-Al-based alloy (sendust), an Fe-Ni-based alloy (permalloy), an Fe-Cu-Ni-based alloy (permalloy), an Fe-Co-based alloy (permendur), an Fe-Cr-Si-based alloy (electromagnetic stainless steel), an Nd-Fe-B-based alloy (rare-earth magnet), an Sm-Fe-N-based alloy (rare-earth magnet), an Al-Ni-Co-based alloy (alnico magnet), and ferrite. The ferrite may be, for example, spinel ferrite, hexagonal ferrite, or garnet ferrite. The metal element-containing powder may be a copper alloy such as a Cu-Sn-based alloy, a Cu-Sn-P-based alloy, a Cu-Ni-based alloy, or a Cu-Be-based alloy. The metal element-containing powder may contain one kind of the above-described elements and compositions or may contain a plurality of kinds of the above-described elements and compositions.

The metal element-containing powder may be an Fe simple substance. The metal element-containing powder may be an alloy containing iron (Fe-based alloy). The Fe-based alloy may be, for example, an Fe-Si-Cr-based alloy or an Nd-Fe-B-based alloy. The metal element-containing powder may be at least any one of an amorphous iron powder and a carbonyl iron powder. In a case where the metal element-containing powder contains at least any one of an Fe simple substance and an Fe-based alloy, it is easy to produce a molded body having a high space factor and excellent magnetic property from the compound. The metal element-containing powder may be an Fe amorphous alloy. As commercially available products of the Fe amorphous alloy powder, for example, at least one selected from the group consisting of AW2-08 and KUAMET-6B2 (all of which are manufactured by EPSON ATMIX Corporation, trade names), DAP MS3, DAP MS7, DAP MSA10, DAP PB, DAP PC, DAP MKV49, DAP 410L, DAP 430L, and DAP HYB series (all of which are manufactured by Daido Steel Co., Ltd., trade names), and MH45D, MH28D, MH25D, and MH20D (all of which are manufactured by Kobe Steel, Ltd., trade names) may be used.

<Method for producing compound>

In the production of the compound, the metal element-containing powder and the resin composition (each component constituting the resin composition) are mixed while being heated. For example, the metal element-containing powder and the resin composition may be kneaded by a kneader, a roll, a stirrer, or the like while being heated. By heating and mixing the metal element-containing powder and the resin composition, the resin composition adheres to a part of or whole surface of the metal element-containing particle constituting the metal element-containing powder to cover the metal element-containing particle, and a part of or whole epoxy resin in the resin composition becomes a semi-cured product. As a result, a compound is obtainable. A wax may be further added to the powder obtained by heating and mixing the metal element-containing powder and the resin composition, and thereby a compound may be obtainable. The resin composition and a wax may be mixed in advance.

In kneading, the metal element-containing powder, the siloxane chemical compound, the epoxy resin, the curing agent such as a phenolic resin, the curing accelerator, and the coupling agent may be kneaded in a bath. After the metal element-containing powder, the siloxane chemical compound, and the coupling agent are charged in the bath and mixed, the epoxy resin, the curing agent, and the curing accelerator are charged in the bath, and the raw materials in the bath may be kneaded. After the siloxane chemical compound, the epoxy resin, the curing agent, and the coupling agent are kneaded in the bath, the curing accelerator is put in the bath, and the raw materials in the bath may be further kneaded. A mixed powder (resin mixed powder) of the epoxy resin, the curing agent, and the curing accelerator is prepared in advance, the metal element-containing powder, the siloxane chemical compound, and the coupling agent are subsequently kneaded to prepare a metal mixed powder, and the metal mixed powder and the above-described resin mixed powder may be subsequently kneaded.

The kneading time varies depending on the type of a kneading machine, the volume of a kneading machine, and the amount of a compound produced, and for example, is preferably 1 minute or longer, more preferably 2 minutes or longer, and further preferably 3 minutes or longer. Furthermore, the kneading time is preferably 20 minutes or shorter, more preferably 15 minutes or shorter, and further preferably 10 minutes or shorter. In a case where the kneading time is shorter than 1 minute, kneading is not sufficient, the moldability of the compound is impaired, and a variation in cure extent of the compound occurs. In a case where the kneading time is longer than 20 minutes, for example, curing of the resin composition (for example, an epoxy resin and a phenolic resin) in a bath is advanced, and thus the fluidity and the moldability of the compound are likely to be impaired. In a case where raw materials in the bath are kneaded while being

heated, the heating temperature may be, for example, a temperature at which a semi-cured product (B-stage epoxy resin) of an epoxy resin is generated and generation of a cured product (C-stage epoxy resin) of an epoxy resin is suppressed. The heating temperature may be a temperature lower than an activation temperature of a curing accelerator. The heating temperature is, for example, preferably 50°C or higher, more preferably 60°C or higher, and further preferably 70°C or higher. The heating temperature is preferably 150°C or lower, more preferably 120°C or lower, and further preferably 110°C or lower. In a case where the heating temperature is within the above-described ranges, the resin composition in the bath is softened, and thereby the resin composition is likely to cover the surface of the metal element-containing particle constituting the metal element-containing powder, a semi-cured product of the epoxy resin is easily generated, and complete curing of the epoxy resin during kneading is easily suppressed.

<Molded body>

The molded body of the present embodiment may include the above-described compound. A molded body of the present embodiment may include a cured product of the above-described compound. The molded body may contain at least one selected from the group consisting of the resin composition which is uncured, a semi-cured product of the resin composition (B-stage resin composition), and a cured product of the resin composition (C-stage resin composition). The molded body of the present embodiment may be used as a sealing material for an electronic component or an electronic circuit board. According to the present embodiment, cracks of a molded body due to a difference in thermal expansion rate between a metallic member of an electronic component or an electronic circuit board and a molded body (sealing material) can be suppressed.

<Method for producing molded body>

A method for producing a molded body of the present embodiment may include a step of pressurizing the compound in a mold. The method for producing a molded body may include a step of pressurizing the compound partially or entirely covering the surface of the metallic member in a mold. The method for producing the molded body may include only the step of pressurizing the compound in a mold or may include other steps in addition to the pressurizing step. The method for producing a molded body may include a first step, a second step, and a third step. Hereinafter, details of each step will be described.

In the first step, the compound is produced by the above-described method.

In the second step, the compound is pressurized in the mold, and thereby a molded body (B-stage molded body) is obtained. In the second step, the compound partially or entirely covering the surface of the metallic member is pressurized in the mold, and thereby a molded body (B-stage molded body) may be obtained. In the second step, the resin composition is filled between the metal element-containing particles constituting the metal element-containing powder. Further, the resin composition functions as a bonding material (binder) and binds the metal element-containing particles to each other.

As the second step, the transfer molding of the compound may be executed. In the transfer molding, the compound may be pressurized at 5 MPa or more and 50 MPa or less. As the molding pressure is increased, there is a tendency that a molded body excellent in mechanical strength is easily obtained. In the case of taking into consideration of the mass productivity of a molded body and the lifetime of a mold, the molding pressure is preferably 8 MPa or more and 20 MPa or less. The density of a molded body formed by the transfer molding may be preferably 75% or more and 86% or less and more preferably 80% or more and 86% or less with respect to the true density of the compound. In a case where the density of a molded body is 75% or more and 86% or less, a molded body excellent in mechanical strength is easily obtained. In the transfer molding, the second step and the third step may be executed at once.

In the third step, the molded body is cured by a heat treatment to obtain a C-stage molded body. The heat treatment temperature is sufficient to be a temperature at which the resin composition in the molded body is sufficiently cured. The heat treatment temperature may be preferably 100°C or higher and 300°C or lower and more preferably 110°C or higher and 250°C or lower. In order to suppress the oxidation of the metal element-containing powder in the molded body, the heat treatment is preferably performed under an inert atmosphere. In a case where the heat treatment temperature is higher than 300°C, the metal element-containing powder may be oxidized by a trace amount of oxygen inevitably contained in the atmosphere of the heat treatment, or the resin cured product may be degraded. In order to sufficiently cure the resin composition while suppressing the oxidation of the metal element-containing powder and the degradation of the resin cured product, the maintaining time for the heat treatment temperature may be preferably several minutes or longer and 10 hours or shorter and more preferably 3 minutes or longer and 8 hours or shorter.

<Electronic component>

As illustrated in FIGS. 2(a) and 2(b), electronic components 10a and 10b of the present embodiment include

a cured product 2 of the above-described compound and a device 3 covered with the cured product 2 of the compound. The device 3 may have a metallic member. The device 3 is not particularly limited, but may be, for example, at least one selected from the group consisting of a semiconductor chip, an MEMS (microelectromechanical system), and a coil. The semiconductor chip is not particularly limited, and may be at least one selected from the group consisting of IC, LSI, system LSI, SRAM, DRAM, and flash memory. The metallic member of the device 3 may contain at least one selected from the group consisting of copper (Cu), gold (Au), silver (Ag), and nickel (Ni). The metallic member may be, for example, a coil. The metallic member may be an outer lead that is a part of an interposer (lead frame). The metallic member may be an inner lead connecting the device 3 and an outer lead to each other. The metallic member may be a bonding wire.

As illustrated in FIGS. 2(a), the electronic component 10a may include a cured product 2 of the above-described compound and a device 5 embedded in the cured product 2 of the compound. In other words, the electronic component 10a may include the device 5 and the cured product 2 of the compound covering the entire device 5. The device 5 may have a metallic member. For example, the device 5 may be a coil and the electronic component 10a may be an inductor, a filter (for example, EMI filter), or a transformer.

As illustrated in FIG. 2(b), a part of the device 3 covered with the cured product 2 of the compound may extend outside the cured product 2 of the compound. In other words, the electronic component 10b may include the device 3 and the cured product 2 of the compound partially covering the device 3. The device 3 may have a metallic member. For example, the electronic component 10b may be a semiconductor package, which includes an interposer 9 (lead frame), a semiconductor chip 7 installed on the interposer 9, and the cured product 2 of the compound covering the interposer 9 and the semiconductor chip 7, and an outer lead that is a part of the interposer 9 may extend outside the cured product 2 of the compound.

<Electronic circuit board>

As illustrated in FIG. 3, an electronic circuit board 100 of the present embodiment may include a board 11 and the above-described electronic component 10a installed on the surface of the board 11. The board 11 is not particularly limited, and for example, may be at least printed-circuit board selected from the group consisting of a rigid board, a flexible board, and a rigid-flexible board. The electronic component 10a may be electrically connected to an electronic circuit installed on the surface of the board 11 by the reflow treatment, for example. The cured product 2 of the compound of the electronic component 10a is formed from the compound in which SI is within the above-described range. Therefore, when the electronic component 10a is heated by the reflow treatment, cracks due to a difference in thermal expansion rate between the cured product 2 of the compound and the metallic member of the device 5 is suppressed.

**Examples**

Hereinafter, the present invention will be described in more detail by Examples and Comparative Examples; however, the present invention is not limited by these examples at all.

(Example 1)

[Preparation of compound]

100 g of a biphenylene aralkyl type epoxy resin, 38.7 g of a phenol novolac resin (curing agent), 2.0 g of a curing accelerator, and 7.0 g of a montanoic acid ester (wax) were charged in a poly container. These raw materials were mixed in the poly container for 10 minutes and thereby a resin mixture was prepared. The resin mixture corresponds to other whole components of the resin composition excluding the chemical compound having a siloxane bond and the coupling agent.

As the biphenylene aralkyl type epoxy resin, NC-3000 manufactured by Nippon Kayaku Co., Ltd. was used.

As the phenol novolac resin, HP-850N manufactured by Hitachi Chemical Company, Ltd. was used.

As the curing accelerator, 2-ethyl-4-methylimidazole (2E4MZ) manufactured by SHIKOKU CHEMICALS CORPORATION was used.

As the montanoic acid ester, LICOWAX-E manufactured by Clariant Chemicals Co., Ltd. was used.

An amorphous iron powder 1 and an amorphous iron powder 2 were uniformly mixed for 5 minutes by a pressure biaxial kneader (manufactures by Nihon Spindle Manufacturing Co., Ltd., capacity: 5 L) and thereby 3835 g of a metal element-containing powder was prepared. The content of the amorphous iron powder 1 in the metal element-containing powder was 75% by mass. The content of the amorphous iron powder 2 in the metal element-containing powder was 25% by mass. 3.0 g of 3-glycidoxypropyltrimethoxysilane (coupling agent) and 30 g of caprolactone-modified dimethyl silicone (chemical compound having a siloxane bond) were added to the metal element-containing powder in the biaxial kneader. Subsequently, the contents in the biaxial kneader were heated to 90°C, and the contents in the biaxial kneader

were mixed for 10 minutes while the temperature was maintained. Subsequently, the above-described resin mixture was added to the contents in the biaxial kneader, and the contents were melted and kneaded for 15 minutes while the temperature of the contents was maintained at 120°C. After the kneaded product obtained by melting and kneading described above was cooled to room temperature, the kneaded product was ground by a hammer until the kneaded product had a predetermined particle size. Incidentally, the "melting" described above means melting of at least a part of the resin composition of the contents in the biaxial kneader. The metal element-containing powder in the compound is not melted in the preparation process of the compound.

As the amorphous iron powder 1, 9A4-II (average particle size: 24 $\mu$m) manufactured by EPSON ATMIX Corporation was used.

As the amorphous iron powder 2, AW2-08 (average particle size: 5.3 $\mu$m) manufactured by EPSON ATMIX Corporation was used.

As the 3-glycidoxypropyltrimethoxysilane, KBM-403 manufactured by Shin-Etsu Chemical Co., Ltd. was used.

As the caprolactone-modified dimethyl silicone, DBL-C32 manufactured by Gelest Inc. was used. This caprolactone-modified dimethyl silicone is a chemical compound represented by the above-described chemical formula (3).

A compound of Example 1 was prepared by the method described above. The content of the metal element-containing powder in the compound was 95.5% by mass.

[Evaluation of fluidity]

50 g of the compound of Example 1 was charged into a transfer tester, and the spiral flow amount (unit: mm) of the compound was measured at a mold temperature (molding temperature) of 140°C, an injection pressure of 13.5 MPa, and a molding time of 360 seconds. The spiral flow amount is a length of the softened or liquefied compound flowing in a spiral curve (Archimedean) groove formed in the above-described mold. That is, the spiral flow amount is a flow distance of the softened or liquefied compound. As the compound softened or liquefied by heating flows more easily, the spiral flow amount is large. That is, the spiral flow amount of the compound excellent in fluidity is large. As the transfer tester, a transfer molding machine manufactured by TECHNO MARUSHICHI CO., LTD. was used. As the mold, a mold for spiral flow measurement according to ASTM D3123 was used. The spiral flow amount of Example 1 is shown in Table 2 below.

[Bending test]

A test piece 1 illustrated in FIG. 1 was obtained by the transfer molding of the compound of Example 1 at 140°C. The test piece 1 was a rectangular parallelepiped (rod) consisting of the cured product of the compound. The pressure applied to the compound was 13.5 MPa. The dimension of the test piece 1 was longitudinal width L: 80 mm $\times$ transverse width W: 10 mm $\times$ thickness t: 3.0 mm. Three-point support type bending test was executed with respect to the test piece 1 by using an autograph equipped with a thermostat bath. As the autograph, AGS-500A manufactured by SHIMADZU CORPORATION was used. The temperature of the thermostat bath was 250°C. As illustrated in FIG. 1, in the bending test, one surface of the test piece 1 was supported by two support points. A load was applied to the center position between the two support points in the other surface of the test piece 1. A load when the test piece 1 is broken and deflection (expansion amount) of the test piece 1 immediately before the test piece 1 is broken were measured. Measurement conditions of the bending test were as follows.

Distance Lv between two support points: 64.0 $\pm$ 0.5 mm
Head speed: 2.0 $\pm$ 0.2 mm/min
Chart speed: 100 mm/min
Chart full scale: 490 N (50 kgf)

The bending strength $\sigma$ (unit: MPa) was calculated on the basis of the mathematical formula (A) below. The bending elastic modulus E (unit: GPa) was calculated on the basis of the mathematical formula (B) below. The bending elongation rate $\varepsilon$ (unit: %) was calculated on the basis of the mathematical formula (C) below. In mathematical formula below, "P" is a load (unit: N) when the test piece 1 is broken. "Lv" is a distance (unit: mm) between two support points. "W" is a transverse width (unit: mm) of the test piece 1. "t" is a thickness (unit: mm) of the test piece 1. "F/Y" is a gradient (unit: N/m) of the straight-line segment of the load-deflection curve. "s" is deflection (unit: mm) of the test piece 1 immediately before the test piece 1 is broken. $\sigma$, E, and $\varepsilon$ of Example 1 are shown in Table 2 below.

$$\sigma = (3 \times P \times Lv)/(2 \times W \times t^2) \quad (A)$$

$$E = [Lv^3/(4 \times W \times t^3)] \times (F/Y) \quad (B)$$

$$\varepsilon = (600 \times s \times t)/Lv^2 \quad (C)$$

[Calculation of fracture index FI]

The fracture index FI (unit: MPa) was calculated on the basis of mathematical formula (II) below by using the result of the bending test described above. FI of Example 1 is shown in Table 2 below.

$$FI = \varepsilon \times \sigma/2 \quad (II)$$

[Thermo mechanical analysis]

The thermo mechanical analysis (TMA) was performed with respect to the compound of Example 1. In TMA, the compound of Example 1 was molded under conditions of 140°C, 360 seconds, and 13.5 MPa, then a molded body of the compound was cured at 180°C for 2 hours, and thereby a test piece (a cured product of the compound) was prepared. In TMA, the test piece was heated from room temperature (25°C) to 250°C. The load applied to the test piece in TMA was 10 g. The heating rate was 5°C/min. The glass transition temperature Tg (unit: °C) of the cured product of the compound, the thermal expansion rate CTE1 (unit: ppm/°C) of the cured product of the compound at 25°C or higher and lower than Tg°C, and the thermal expansion rate CTE2 (unit: ppm/°C) of the cured product of the compound at Tg°C or higher and 250°C or lower were obtained on the basis of the results of TMA. Tg, CTE1, and CTE2 of Example 1 are shown in Table 2 below.

[Calculation of difference D in expansion amount]

The difference D in expansion amount between the cured product of the compound of Example 1 and copper at 25°C to 250°C was calculated on the basis of mathematical formula (III) below by using the result of the thermo mechanical analysis described above. D of Example 1 is shown in Table 2 below.

$$D = CTE1 \times (Tg - 25) + CTE2 \times (250 - Tg) - 17 \times (250 - 25) \quad (III)$$

[Calculation of stress index SI]

The stress index SI was calculated on the basis of mathematical formula (I) below by using the results of the bending test and the thermo mechanical analysis described above. SI of Example 1 is shown in Table 1 below. SI is equal to D × E/σ.

$$SI = |[CTE1 \times (Tg - 25) + CTE2 \times (250 - Tg) - 17 \times (250 - 25)] \times E/\sigma| \quad (I).$$

[Reflow treatment]

By the transfer molding, the metallic member made of copper was sealed with the compound of Example 1, the compound was cured, and thereby a molded body was obtained. The molded body was subjected to the reflow treatment. The highest heating temperature in the reflow treatment was 260°C. The heating time was 300 seconds. After the reflow treatment, the molded body was observed and existence of cracks in the molded body of Example 1 was checked. The result of the reflow treatment of Example 1 is shown in Table 2 below. "A" described in the following table means that cracks are not formed in the molded body. "B" means that cracks are formed in the molded body.

(Examples 2 to 6)

In Examples 2 to 6, compositions shown in Table 1 below were used as raw materials for the compound. The mass (unit: g) of each composition used in Examples 2 to 6 was a value shown in Table 1 below. Each of compounds of Examples 2 to 6 was individually produced by the same method as in Example 1 except for these matters. Measurement and evaluation for each compound of Examples 2 to 6 were performed by the same method as in Example 1. The results of the measurement and the evaluation of each of Examples 2 to 6 are shown in Table 2 below.

(Comparative Example 1)

In Comparative Example 1, compositions shown in Table 1 below were used as raw materials for the compound. The mass (unit: g) of each composition used in Comparative Example 1 was a value shown in Table 1 below. A compound of Comparative Example 1 was produced by the same method as in Example 1 except for these matters. Measurement and evaluation for the compound of Comparative Example 1 were performed by the same method as in Example 1. The results of the measurement and the evaluation of Comparative Example 1 are shown in Table 2 below.

AER-4001 described in the following table is an isocyanate-modified epoxy resin manufactured by Asahi Kasei Corp. (former Asahi Kasei E-materials Corp.).

MEHC-7851SS described in the following table is a biphenylene aralkyl type phenolic resin (curing agent) manufactured by Meiwa Plastic Industries, Ltd.

C11Z described in the following tables is 2-undecylimidazole (curing accelerator) manufactured by SHIKOKU CHEMICALS CORPORATION.

[Table 1]

| Table 1 | Product name | Example 1 | Example 2 | Example 3 | Example 4 | Example 5 | Example 6 | Comparative Example 1 |
|---|---|---|---|---|---|---|---|---|
| Epoxy resin (g) | NC-3000 | 100 | 50 | 75 | 100 | 100 | 100 | 100 |
| | AER-4001 | - | 50 | 25 | - | - | - | - |
| Curing agent (g) | HP-850N | 38.7 | - | - | - | 21.8 | 29.0 | 38.7 |
| | MEHC-7851SS | - | 70.4 | 71.5 | 67.2 | 13.6 | - | - |
| Curing accelerator (g) | C11Z | - | 1.0 | 1.0 | 1.0 | - | 2.2 | - |
| | 2E4MZ | 2.0 | 1.75 | 1.3 | 1.3 | 2.3 | 1.0 | 2.0 |
| Coupling agent (g) | KBM-403 | 3.0 | 4.0 | 4.0 | 4.0 | 3.0 | 3.0 | 3.0 |
| Release agent (g) | LICOWAX-E | 7.0 | 8.0 | 8.0 | 8.0 | 7.0 | 7.0 | 7.0 |
| Chemical compound having siloxane bond (g) | DBL-C32 | 30 | 35 | 35 | 35 | 30 | 30 | - |
| Metal element-containing powder (g) | | 3835 | 4672 | 4686 | 4595 | 3771 | 3655 | 3198 |
| Total (g) | | 4016 | 4892 | 4907 | 4811 | 3949 | 3827 | 3349 |
| Content (mass%) of metal element-containing powder | | 95.5 | 95.5 | 95.5 | 95.5 | 95.5 | 95.5 | 95.5 |

[Table 2]

| Table 2 | | Example 1 | Example 2 | Example 3 | Example 4 | Example 5 | Example 6 | Comparative Example 1 |
|---|---|---|---|---|---|---|---|---|
| Spiral flow amount (mm) | | 430 | 430 | 470 | 493 | 495 | 483 | 430 |
| Bending test | Bending elongation rate ε (%) | 1.31 | 2.07 | 1.8 | 1.43 | 1.47 | 1.31 | 0.80 |
| | Bending elastic modulus E (GPa) | 0.43 | 0.25 | 0.4 | 0.39 | 0.42 | 0.42 | 0.80 |
| | Bending strength σ (MPa) | 6.45 | 4.53 | 5.40 | 5.58 | 5.23 | 5.06 | 7.2 |
| Fracture index FI (MPa) | | 4.22 | 4.69 | 4.86 | 3.99 | 3.84 | 3.31 | 2.88 |
| Tg (°C) | | 175.5 | 193 | 187.6 | 184.9 | 177.1 | 174.9 | 169 |
| CTE1 (ppm/°C) | | 10.3 | 10.6 | 10.1 | 11.4 | 15.1 | 10.9 | 13.5 |
| CTE2 (ppm/°C) | | 35 | 34.4 | 37.3 | 39.6 | 43.5 | 47.4 | 40 |
| Difference D in expansion amount | | 333 | -83 | 145 | 576 | 1643 | 1369 | 1359 |
| Stress index SI | | 22.2 | 4.6 | 10.7 | 40.2 | 131.9 | 113.6 | 151.0 |
| Reflow treatment | | A | A | A | A | A | A | B |

## Industrial Applicability

The compound of the present invention has a high industrial value since cracks in a molded body produced from the compound and the metallic member can be suppressed.

## Reference Signs List

1: test piece, 2: cured product of compound, 3, 5: device, 7: semiconductor chip, 9: interposer, 10a, 10b: electronic component, 11: board, 100: electronic circuit board, P: load, Lv: distance between support points, L: longitudinal width of test piece, W: transverse width of test piece, t: thickness of test piece.

## Claims

**1.** A compound comprising:

a metal element-containing powder; and
a resin composition, wherein
a content of the metal element-containing powder is 90% by mass or more and less than 100% by mass.
a glass transition temperature of a cured product of the compound is represented as Tg [°C],
a thermal expansion rate of the cured product of the compound at 25°C or higher and lower than $T_g$[°C] is represented as CTE1 [ppm/°C],
a thermal expansion rate of the cured product of the compound at Tg°C or higher and 250°C or lower is represented as CTE2 [ppm/°C],
a bending elastic modulus of the cured product of the compound at 250°C is represented as E [GPa],
a bending strength of the cured product of the compound at 250°C is represented as σ [MPa],
a stress index SI of the cured product of the compound defined by mathematical formula (I) below is 0 or more and 150 or less:

$$SI = |[CTE1 \times (Tg - 25) + CTE2 \times (250 - Tg) - 17 \times (250 - 25)] \times E/\sigma| \quad (I),$$

a bending elongation rate of the cured product of the compound at 250°C is represented as ε [%], and
a fracture index FI defined by mathematical formula (II) below is 3.0 MPa or more and 10.0 MPa or less:

$$FI = \varepsilon \times \sigma/2 \quad (II),$$

a three-point support type bending test is executed with respect to a test piece (1) by using an autograph equipped with a thermostat bath,
the test piece is a rectangular parallelepiped consisting of the cured product of the compound,
a dimension of the test piece is longitudinal width L × transverse width W × thickness t,
a temperature of the thermostat bath is 250°C,
one surface of the test piece is supported by two support points in the three-point support type bending test,
a load is applied to the center position between the two support points in the other surface of the test piece,
a load when the test piece is broken and deflection of the test piece immediately before the test piece is broken are measured,
P [N] is the load when the test piece is broken,
Lv [mm] is a distance between the two support points,
W [mm] is the transverse width of the test piece,
t [mm] is the thickness of the test piece,
F/Y [N/m] is a gradient of a straight-line segment of a load-deflection curve measured by the three-point support type bending test,
s [mm] is the deflection of the test piece immediately before the test piece is broken,
the bending strength is calculated on the basis of mathematical formula (A) below:

$$\sigma = (3 \times P \times Lv)/(2 \times W \times t^2) \text{ (A)},$$

the bending elastic modulus is calculated on the basis of mathematical formula (B) below:

$$E = [Lv^3/(4 \times W \times t^3)] \times (F/Y) \text{ (B)},$$

the bending elongation rate is calculated on the basis of mathematical formula (C) below:

$$\varepsilon = (600 \times s \times t)/Lv^2 \text{ (C)}.$$

**2.** A molded body comprising a cured product of the compound according to claim 1.

**3.** An electronic component (10a, 10b) comprising:

a cured product (2) of the compound according to claim 1; and
a device (3) covered with the cured product of the compound, wherein
the device has a metallic member.

**Patentansprüche**

**1.** Verbundwerkstoff, umfassend:

ein Metallelement-haltiges Pulver und
eine Harzzusammensetzung, wobei
ein Gehalt des Metallelement-haltigen Pulvers 90 Masse-% oder mehr und weniger als 100 Masse-% beträgt,
eine Glasübergangstemperatur eines gehärteten Produkts des Verbundwerkstoffs als Tg [°C] dargestellt ist,
eine Wärmeausdehnungsrate des gehärten Produkts des Verbundwerkstoffs bei 25°C oder höher und niedriger als Tg [°C] als CTE1 [ppm/°C] dargestellt ist,
eine Wärmeausdehnungsrate des gehärteten Produkts des Verbundwerkstoffs bei Tg°C oder höher und 250°C oder niedriger als CTE2 [ppm/°C] dargestellt ist,
ein Biegeelastizitätsmodul des gehärteten Produkts des Verbundwerkstoffs bei 250°C als E [GPa] dargestellt ist,
eine Biegefestigkeit des gehärteten Produkts des Verbundwerkstoffs bei 250°C als σ [MPa] dargestellt ist,
ein Spannungsindex SI des gehärteten Produkts des Verbundwerkstoffs, definiert durch die nachstehende mathematische Formel (I), 0 oder mehr und 150 oder weniger beträgt:

$$SI = |[CTE1 \times Tg - 25) + CTE2 \times (250 - Tg) - 17 \times (250 - 25)] \times E/\sigma| \quad \text{(I)},$$

eine Biegedehnungsrate des gehärteten Produkts des Verbundwerkstoffs bei 250°C als ε [%] dargestellt ist und
ein Bruchindex FI, definiert durch die nachstehende mathematische Formel (II), 2,0 MPa oder mehr und 10,0 MPa oder weniger beträgt:

$$FI = \varepsilon \times \sigma/2 \quad \text{(II)},$$

ein Biegeversuch vom Typ Dreipunkt-Auflage bezüglich eines Prüfkörpers (1) durchgeführt wird, indem ein mit einem Thermostatbad ausgestatteter Autograph verwendet wird,
der Prüfkörper ein rechteckiges Parallelepiped, bestehend aus dem gehärteten Produkt des Verbundwerkstoffs, ist,
eine Abmessung des Prüfkörpers Längsbreite L × Querbreite W × Dicke t ist,
eine Temperatur des Thermostatbads 250°C beträgt,
eine Oberfläche des Prüfkörpers durch zwei Auflagepunkte in dem Biegeversuch vom Typ Dreipunkt-Auflage gestützt wird,

eine Last an die Mittelstellung zwischen den beiden Auflagepunkten in der anderen Oberfläche des Prüfkörpers angelegt wird,
eine Last, wenn der Prüfkörper zerbricht, und eine Verformung des Prüfkörpers, direkt bevor der Prüfkörper zerbricht, gemessen werden,
P [N] die Last ist, wenn der Prüfkörper zerbricht,
Lv [mm] ein Abstand zwischen den beiden Auflagepunkten ist,
W [mm] die Querbreite des Prüfkörpers ist,
t [mm] die Dicke des Prüfkörpers ist,
F/Y [N/m] ein Gradient eines geraden Liniensegments einer Last-Biegelinie, gemessen durch den Biegeversuch vom Typ Dreipunkt-Auflage, ist,
s [mm] die Verformung des Prüfkörpers, direkt bevor der Prüfkörper zerbricht, ist,
die Biegefestigkeit auf Basis der nachstehenden mathematischen Formel (A) berechnet wird:

$$\sigma = (3 \times P \times Lv)/(2 \times W \times t^2) \quad (A),$$

der Biegeelastizitätsmodul auf Basis der nachstehenden mathematischen Formel (B) berechnet wird:

$$E = [Lv^3/(4 \times W \times t^3)] \times (F/Y) \quad (B)$$

und
die Biegedehnungsrate auf Basis von nachstehender mathematischer Formel (C) berechnet wird:

$$\varepsilon = (600 \times s \times t)/Lv^2 \quad (C).$$

**2.** Formkörper, umfassend ein gehärtetes Produkt des Verbundwerkstoffs gemäß Anspruch 1.

**3.** Elektronisches Bauteil (10a, 10b), umfassend:

ein gehärtetes Produkt (2) des Verbundwerkstoffs gemäß Anspruch 1 und
eine Vorrichtung (3), die mit dem gehärteten Produkt des Verbundwerkstoffs bedeckt ist, wobei die Vorrichtung ein metallisches Teil aufweist.

**Revendications**

**1.** Composé comprenant :

une poudre contenant un élément métallique ; et
une composition de résine, dans lequel
une teneur en poudre contenant un élément métallique est supérieure ou égale à 90 % en masse et inférieure à 100 % en masse.
une température de transition vitreuse d'un produit durci du composé est représentée par Tg [°C],
un taux de dilatation thermique du produit durci du composé à 25 °C ou plus et inférieur à Tg[°C] est représenté par CTE1 [ppm/°C],
un taux de dilatation thermique du produit durci du composé à Tg°C ou plus et 250°C ou moins est représenté par CTE2 [ppm/°C],
un module d'élasticité en flexion du produit durci du composé à 250 °C est représenté par E [GPa],
une résistance à la flexion du produit durci du composé à 250 °C est représentée par σ [MPa],
un indice de contrainte SI du produit durci du composé défini par la formule mathématique (I) ci-dessous est de 0 ou plus et de 150 ou moins :

$$SI = |[CTE1 \times (Tg - 25) + CTE2 \times (250 - Tg) - 17 \times (250 - 25)] \times E/\sigma| \quad (I),$$

un taux d'allongement en flexion du produit durci du composé à 250 °C est représenté par ε [%], et

un indice de fracture FI défini par la formule mathématique (II) ci-dessous est de 3,0 MPa ou plus et de 10,0 MPa ou moins :

$$FI = \varepsilon \times \sigma/2 \quad (II),$$

un essai de flexion du type support à trois points est exécuté par rapport à une éprouvette (1) à l'aide d'un autographe équipé d'un bain thermostaté,
l'éprouvette est un parallélépipède rectangle constitué du produit durci du composé,
une dimension de l'éprouvette est la largeur longitudinale L × la largeur transversale W × l'épaisseur t,
une température du bain thermostaté est de 250 °C,
une surface de l'éprouvette est supportée par deux points d'appui dans l'essai de flexion de type support à trois points,
une charge est appliquée à la position centrale entre les deux points d'appui dans l'autre surface de l'éprouvette,
une charge lorsque l'éprouvette est cassée et une déflexion de l'éprouvette immédiatement avant la rupture de l'éprouvette sont mesurées,
P [N] est la charge lorsque l'éprouvette est cassée,
Lv [mm] est une distance entre les deux points d'appui,
W [mm] est la largeur transversale de l'éprouvette,
t [mm] est l'épaisseur de l'éprouvette,
F/Y [N/m] est un gradient d'un segment de droite d'une courbe chargedéformation mesurée par l'essai de flexion du type support à trois points,
s [mm] est la déflexion de l'éprouvette immédiatement avant la rupture de l'éprouvette,
la résistance à la flexion est calculée sur la base de la formule mathématique (A) ci-dessous :

$$\sigma = (3 \times P \times Lv)/(2 \times W \times t^2) \quad (A),$$

le module d'élasticité en flexion est calculé sur la base de la formule mathématique (B) ci-dessous :

$$E = [Lv^3/(4 \times W \times t^3)] \times (F/Y) \quad (B),$$

le taux d'allongement en flexion est calculé sur la base de la formule mathématique (C) ci-dessous :

$$\varepsilon = (600 \times s \times t)/Lv^2 \quad (C).$$

**2.** Corps moulé comprenant un produit durci du composé selon la revendication 1.

**3.** Composant électronique (10a, 10b) comprenant :

un produit durci (2) du composé selon la revendication 1 ; et un dispositif (3) recouvert du produit durci du composé, dans lequel
le dispositif présente un élément métallique.

***Fig.1***

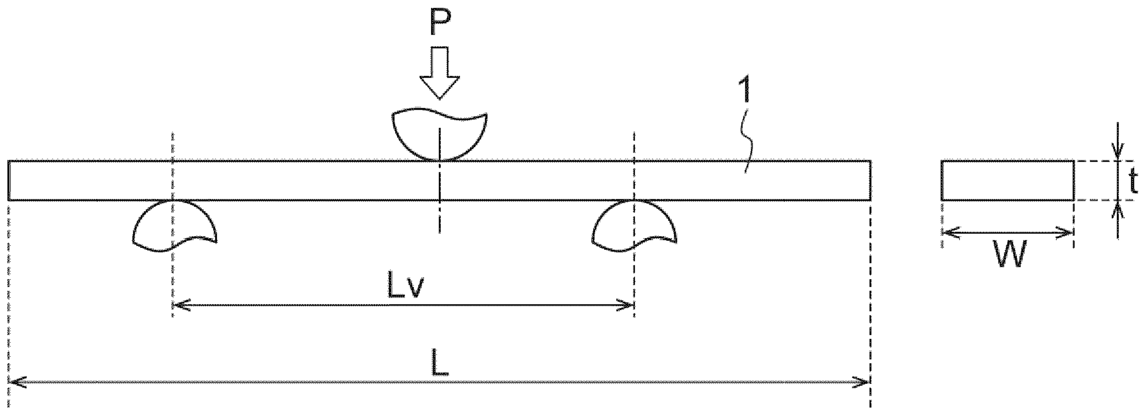

Fig.2

(a)

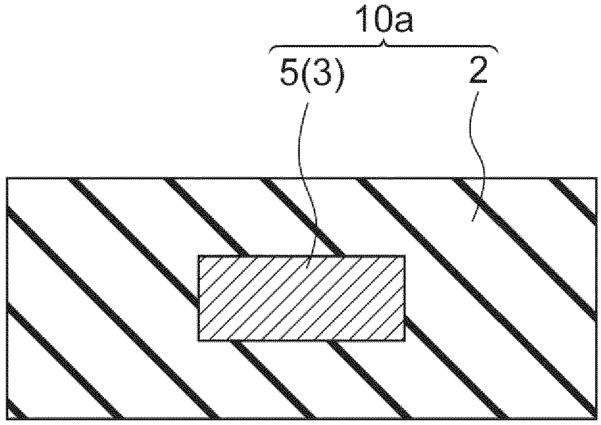


(b)

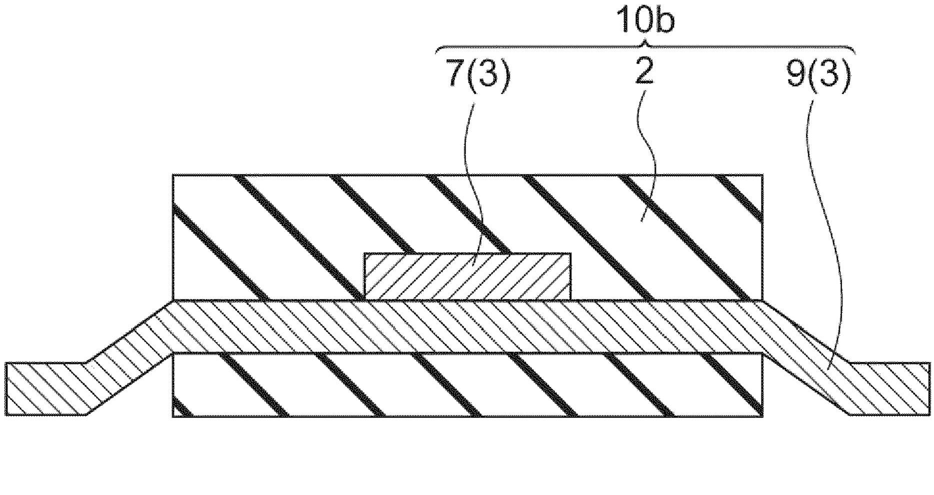

Fig.3

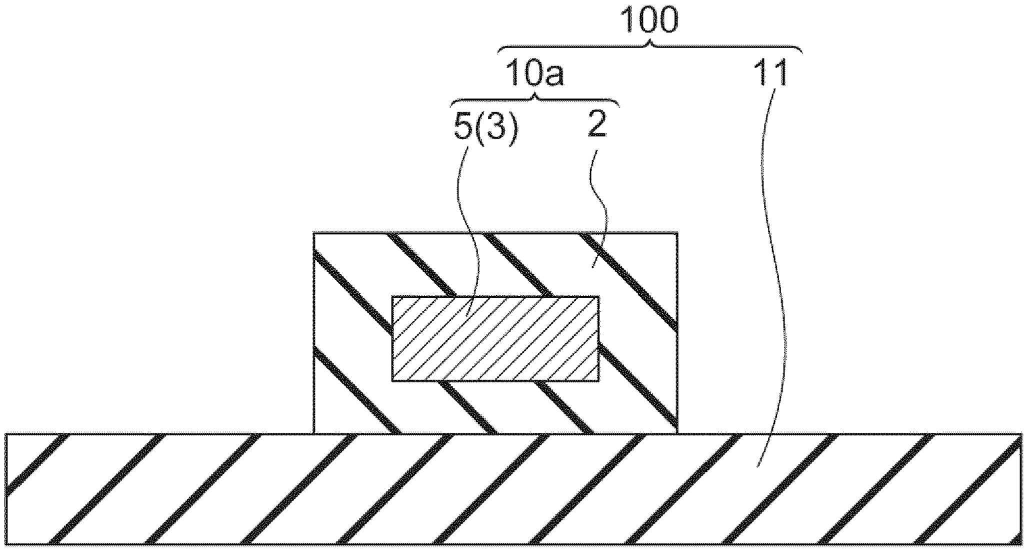

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H07242732 A
- JP H1060085 B
- JP 2014013803 A
- JP H1060085 A


### Non-patent literature cited in the description


- Stress Reduction of Epoxy Molding Compound and Its Effect on Delamination. **XINYU DU et al.** 2007 International Symposium on High Density Packaging and Microsystem Integration. IEEE, June 2007, 1-5